# EUROPEAN PATENT APPLICATION

(11) **EP 2 273 546 A1**
(43) Date of publication of application: **12.01.2011**
(21) Application number: 09165092.9
(22) Date of filing: 09.07.2009
(51) Int. Cl.: H01L 21/68

(54) **Method for releasing a component from a thermal release tape**

(71) Applicant: NXP B.V., 5656 AG Eindhoven (NL)
(72) Inventor: Verhelst, Bas, Redhill, Surrey RH1 1DL (GB)
(74) Representative: Williamson, Paul Lewis

(57) **Abstract**

Method and system for releasing a component from a thermal release tape, the method comprising: attaching a component or an object to be diced into components, for example a wafer, to the thermal release tape; optionally singulating (cutting) the object into components (dies); applying heat to one of the component and the thermal release tape to reduce adhesive effect between the thermal release tape and the component or to release the component completely from the thermal release tape; and releasing the component by picking up or by dropping.

## Description

### FIELD OF THE INVENTION

This invention relates to the field of handling electronic components.

### BACKGROUND OF THE INVENTION

Today, during the process of manufacturing components in the electronic industry, often components are taken by pick-and-place machines, also automatic placement machines or simple placement machines, and placed in target areas. Examples of components are naked dies or molded components, e.g. a packaged die which may also denoted as a chip. In this context, a die may be a piece of semiconductor material with integrated electronic circuitry. Target areas can be many different things. In case of pick-and-place of a semiconductor die, or simply die, the target area may be a standard leadframe or a tape, respectively.

Once a semiconductor wafer has ready-to-use integrated circuits, it may be put on a foil with an adhesive surface. The wafer is then sawn into individual electronic circuits. These dies have to be picked out of a singulated or singularized wafer onto or into a leadframe. Finally, the die contacts may be bonded to the leadframe contacts by bond wires, or by other means, e.g. flip-chip.

Beside the standard leadframe technology, also Micro Leadframe Packages (MLP) are known as a family of integrated circuit QFN packages, used in surface mounted electronic circuit designs. QFN stands for Quad Flat No-lead package. The QFN packages are near-chip-scale plastic encapsulated packages that use conventional lead frame technology, without peripherally protruding leads, within their construction. Often, after molding an array of these products, these are sawn being on the foil, to be placed in a tape afterwards.

Typically, to pick-up components from foil, a conventional adhesive foil with dies is placed between a collet and a needle. The collet is typically vacuum-operated. The collet has the form of a tube with an open end through which air is sucked in. The placement is done in such a way that the needle, a center of a die, and the collet are vertically or horizontally aligned. During a pick-up operation, the needle may lift the die, eventually cut through the foil, thereby slightly bending the foil in such a way that the die is released from the foil and can be picked-up by the collet. Through the tube of the collet air is sucked in such that the die is sucked towards to collet and keeps it tight to the collet. The collet is then moved for placing the die into a target area. The target area may, for example, be a leadframe for subsequent production steps. Alternatively, the picked-up die can be placed on or in a carrier tape for further production steps or shipment to customers.

Today, problems arise as the dies are becoming smaller and smaller and easier damageable. This is the case in today's semiconductor production environment. The structures on the die are becoming smaller and smaller so that the die with the same amount of electronic components can be reduced with a direct positive impact to costs. Thus, individual dies become smaller, thinner and more vulnerable. Using the conventional needle technique as described above, the die could break, get a crack, or be damaged otherwise. This could lead to a quality issue.

### OBJECT AND SUMMARY OF THE INVENTION

Therefore, it may be an object of the present invention to allow for gently handling a component.

This object is solved by a method for releasing a component from a heat-activated foil and a system for releasing a component from a heat-activated foil according to the independent claims. Advantageous modifications of the inventive method and the inventive system are described in the dependent claims.

According to one exemplary embodiment of the invention, a method for releasing a component from a heat-activated foil is provided, wherein the method comprises (a) attaching the component to the heat-activated foil, (b) installing the heat-activated foil with the attached component into an assembly machine, and (c) applying heat to one of (or to both) the component and the heat-activated foil for reducing an adhesive effect between the heat-activated foil and the component for enabling release of the component. Release may for instance be enabled by weakening an adherence of the component at the heat-activated foil and by subsequently picking up the weakly adhering component, or may be enabled by completely releasing the component from the heat-activated foil solely by the impact of the weakened adherence.

According to another exemplary embodiment of the invention, a system (such as one integrated apparatus or a plurality of machines) for releasing a component from a heat-activated foil is provided, wherein the system comprises (a) an attaching unit adapted for attaching the component to the heat-activated foil, (b) an installation unit adapted for installing the heat-activated foil with the attached component into an assembly machine, and (c) a heat applying unit adapted for applying heat to at least one of the component and the heat-activated foil in the assembly machine for reducing an adhesive effect between the heat-activated foil and the component for releasing the component from the heat-activated foil.

If the component is a wafer, a sawing step can be performed once the wafer is put on the foil.

The term "heat-activated foil" (or heat-activatable foil) may denote a foil, e.g., a substrate or a thin film, that is covered with (or which consists of) an adhesive layer in such a way that components may be attached to the foil, if they are brought into contact with the adhesive. The foil is named "heat-activated" because the adhesive effect between the foil and a component attached thereto can be reduced or made completely ineffective by means of heat, i.e. thermal energy. In other words, the adhesive effect may be only present - to a sufficient extent allowing to reliably keeping the component fixed to the foil during singulation and handling - below a specific threshold temperature. Preferably, the adhesive effect can be switched on or off, i.e. may be basically constantly high below a switch temperature and may become constantly low when the temperature has been above a threshold value for a short time. For example, such a thermal release tape may adhere a component securely at room temperature, but can peel it off easily by an application of heat, for instance by increasing the temperature above 90°C, 120°C, 150°C, or 170°C. Above this respective temperature, a chemical, or a physical or physico-chemical reaction in the tape and or the adhesive layer causes the adhesion to diminish or vanish. Such a switch temperature may be adjusted by adjusting the material properties of the heat-activated foil. An example is a heat-activated foil with the trade name Revalpha tape from Nitto Denko Corporation.

The term "assembly machine" may relate to the electronic manufacturing industry where assembly machines may be used to position electronic or other planar components (e.g. biochips) on a carrier such as a leadframe or, carrier tape or onto printed circuit boards (PCB). But it also may denote a machine that may handle small mechanical parts like small parts for manufacturing watches, electronic instruments, or other micro-machines. It basically may denote an apparatus used to manipulate any form of small parts. Typically, this is done by a robotic arm that moves the component from the foil to the target area. It may also denote a bond machine that bonds electronic chips to other contacts by a bond technology (e.g. eutectic or gluing).

The term "attaching a component" may denote the process of placing a component to an adhesive layer such that the component may cling to the layer and may be fixed onto that layer. Typically, the adhesive effect may be reversible or switchable, in some cases by pure mechanical stress, the usage of chemicals, or - in the case of an embodiment of the invention - by heat or infrared radiation applied to the adhesive layer.

The term "collet" may denote a holding device for holding workpieces. In the semiconductor industry it may be a nozzle with a central hole through which air may be sucked into the collet. In this case, a workpiece may be placed such that it is closing the nozzle and the workpiece is sucked and thus be fixed to the collet by applying a negative pressure. The collet may be lifted, thereby moving and lifting the workpiece. The workpiece or component may be an electronic die, a molded (or packaged) component, another electric, electronic, bio-electronic, bio or mechanical component that may be needed to be picked up and placed in another area.

A system for releasing a component from a heat-activated foil according to an embodiment of the invention may have the advantage that no mechanical stress has to be applied to the component or the heat-activated foil. In case the component is an electronic die from a singulated wafer, not any punctiform pressure, e.g., by a needle needs to be applied to the die in order to release it from a foil. This way, the risk of damage due to scratches, breakage or other mechanical manipulation is widely reduced. In case the damages are not visually recognizable in the conventional production method, the damaged dies or other components would be further processed in the production process and only a final quality test could identify the scratched or broken parts and sort them out. According to an embodiment of the invention, also this risk is greatly reduced due to the effect that the components can be released from the foil without the application of any mechanical forced or just very little mechanical force. If a die is clinging upside down to the foil - meaning the component or the die is below the foil - the component or die may just fall down by means of gravity or any other force to any target area if the component or die is released from the foil. This way, dies could be placed easily on, e.g., a carrier tape. Additionally, a plurality of components or dies could be released at the same time from the foil in that area in which the components or dies are attached to the foil being heated up. Thereby, a larger area of the heat-activated foil covering several components or dies, or a plurality of smaller areas covering a small number of components or dies or just single ones, may be heated-up. This may increase the speed and the effectiveness of a production process dramatically. Taking these measures may allow a gently handling a component such as a die without using a pushing needle and actually without exposing the dies to significant mechanical stress. This way, it can be achieved that the dies do not break or are otherwise damaged.

An inventive system for releasing a component from a heat-activated foil can perform the inventive method, the exemplary advantages described above also apply to the inventive system.

In the following, further exemplary embodiments and aspects of the method will be explained which may apply also to the system.

In one embodiment, it may also be possible to pick-up the released component with a collet or drop the component from the heat-activated foil. Due to the heat-activated foil, the component may be picked-up, lifted, and/or moved to another place without applying mechanical forces, e.g., in form of a needle-push, to the component or die for releasing it from the foil.

Advantageously, the collet may be vacuum-operated in order to handle the component as efficiently and safely as possible. Optionally, the collet may be moved by a robotic arm.

In another embodiment, the component is one of the group of a molded component, an electronic component and an electro-mechanical component, which may be a surface mountable or through-the-hole mountable component. The molded component may be a packaged chip. The method and the system according to an exemplary embodiment can be used advantageously with the just mentioned components or alternatively also with other mechanical components. In contrast to surface mountable devices, "through-the-hole" components may denote components such as mechanical, electro-mechanical, electric or electronic components that have wires or pins that may be put through holes in a printed circuit board to be fixed onto the printed circuit board. Alternatively, any planar components (e.g. biochips) can be handled in this way.

In another embodiment, the component that may have been released and picked-up by a collet may be placed on a printed circuit board for further production steps. Alternatively, multiple components may be picked-up by multiple collets or a multi-collet improving the efficiency of the related production process.

In such or an alternative embodiment, the assembly machine may be a machine for assembling electrical or electronic components on a printed circuit board or putting them into a carrier tape.

In another embodiment the component may be part of a singulated wafer. The inventive method is especially applicable to singulated wafers, wherein one of the dies may be the component. The very sensitive dies may be released from the foil, to which a wafer would be attached to, without mechanical stress from, e.g, a needle releasing a die from an adhesive foil. The singulation may be performed between (a) attaching the component - in this case a wafer - to the heat-activated foil and (b) installing the heat-activated foil with the attached component - here a wafer - into an assembly machine. This way, one integrated process of getting the individual electronic circuits out of a wafer and placing them into their target environment can be achieved. The target environment may be, e.g., a carrier foil, a leadframe, a printed circuit board or the like. In case of other mechanical parts, the components may be placed at any location reachable by the machine.

In one embodiment, the method may comprise dropping the component from the heat-activated foil. In case the component is a die, the die may be dropped onto a carrier tape that may include an adhesive surface for fixing individual dies to the carrier tape. In this case, the distance between the just to be released die and the carrier tape may be below 1 mm or - mathematically spoken - even much smaller than 1 mm, e.g., 0,1 mm.

In another exemplary embodiment the method may include placing the die on a leadframe. Typically, the placing might be done by means of a collet attached to a robot arm. Again, the dies are not exposed to any mechanical stress and thus increasing the yield of the manufacturing production process. In this case, the machine may be a machine for assembling dies into a leadframe or onto a carrier tape.

The heat for releasing a component from a heat-activated foil may be applied in many ways to the heat-activated foil. Exemplary embodiments include the option to produce the heat by means of one of the group consisting of a laser, a lamp, a halogen lamp, a power LED, an IR (infrared) source, radiation generated by a current flowing through a resistor, an electromagnetic field inducing a current in the component, and a chemical reaction that is activated by e.g., light, electricity or other radiation. It should only be achieved that the heat, for instance in form of IR radiation, may activate the heat-activated foil in such a way that the adhesive layer of the foil will be heated for a short amount of time above a temperature point at which the adhesive effect of the heat-activated foil is weakened or completely deactivated. The component might thus be released from the heat-activated foil. A time control of the heat applying means may be required. In an embodiment, applying a short heating pulse (such as a laser pulse or an ohmic heating pulse) may be sufficient for triggering the release of the component.

In order to focus or otherwise apply heat for releasing components from a heat-activated foil, the assembly machine may comprise one of the group consisting of a lens, a diaphragm, a shutter, a timer, a prism, and a mirror, for directing radiation in a time controlled manner towards the component or the heat-activated foil. This way it may be achieved that the positioning of the heat-activated foil and a heat producible unit may be positioned in any way to each other.

In again another embodiment, the dropping of the component from the heat-activated foil may comprise dropping the component to a target location. In a special case, the target location may be a carrier tape for further handling dies in the production process of semiconductor elements, or for a shipment to customers.

These and other aspects of the invention are apparent from and will be elucidated with reference to the embodiments described hereinafter.

### DESCRIPTION OF EMBODIMENTS

The invention will be described in greater detail hereinafter, by way of nonlimiting examples, with reference to the embodiments shown in the drawings:
Fig. 1 illustrates a system according to an exemplary embodiment of the invention.
Fig. 2a and Fig. 2b show a process of releasing an electronic component such as a die from a heat-activated foil to release it directly to an exemplary target area, in this case a receiving substrate on a carrier.
Fig. 2c shows a heat-activated foil, a component in form of a die and a collet.
Fig. 3a shows a sawn wafer with numerous single dies on a foil.
Fig. 3b shows a heated target die that is to be picked from a heat-activated foil.
Fig. 3c shows the wafer without the die that has been released or picked from a heat-activated foil.
Fig. 4a shows a wafer of Fig. 3b as well as a carrier tape.
Fig. 4b shows a wafer without the die that has been released from a heat-activated foil and placed onto a carrier tape.
Fig. 5a to Fig. 5d show a conventional procedure of picking electronic components such as dies from an adhesive foil with the "needle technique".

According to an exemplary embodiment of the invention, non-mechanical means to pick-up semiconductor die from foil are provided.

In the following, some recognitions of the present inventor will be summarized based on which exemplary embodiments have been developed.

In the manufacturing of electronic components, a common step is the pick-up of components from a foil. Examples of components are naked dies or molded components. In a previous production step, a wafer or a mold cap has been attached to a foil and has been sawn, to separate the individual products. A die bonder or taping machine picks up the components from the foil and puts them to a leadframe or tape, respectively.

A conventional method of picking-up die from foil is by means of a needle, which mechanically pushes the die into a collet. The collet then takes over the die for further handling (e.g. attaching to substrate or putting in carrier tape).

It is a common tendency in the semiconductor industry that individual dies become smaller, thinner and more vulnerable. When using the conventional needle technique, the dies could break or crack, leading to non-functional products or quality hazards.

In view of these considerations, the present inventor has developed the following embodiments of the invention.

In an embodiment, it is possible to use non-mechanical means of picking dies from a foil. In this way, less mechanical stress is put on the die, thereby reducing or eliminating the chance of mechanical damage.

An example of such a method is using a heat-activated foil. Heat-activated foil (HAF), e.g. Revalpha tape from Nitto, initially has adhesive power, but this can be reduced to almost zero by applying heat for a short time. The required heat may be generated by means of e.g., a laser beam.

In an embodiment, application of this foil into an assembly equipment may be as follows:
1. Apply a number of unsawn products to a HAF (e.g. a wafer in case of dies and a number of mold caps in case of molded products).
2. Put this in an assembly machine. This machine will apply heat locally, to release one or more products, in this case by a laser beam which fires light during a short interval.
3. Subsequently, the machine picks up the product by means of a collet, using vacuum, or the product drops at the desired place.

For example, heat can be applied to the HAF by:
- a laser with optics to focus the energy to the spot for heating,
- another light source (e.g. power LED, halogen lamp, IR source, etc) with optics (lenses, diaphragm, shutter) to control place and time of heat,
- electrical current generating local power,
- induction by generating a local electromagnetic field, inducing currents in the product, which generate heat locally, or
- a local chemical reaction, for instance triggered by light or electricity

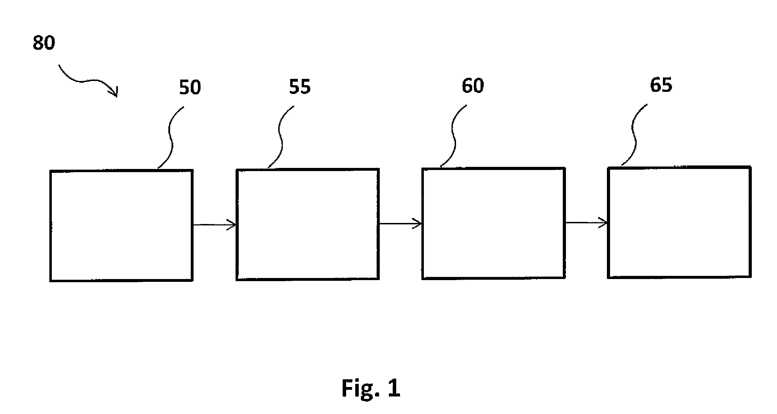

**Fig. 1** illustrates a system 80 for releasing a component from a heat-activated foil according to an exemplary embodiment of the invention.

The system 80 comprises an attaching unit 50 adapted for attaching the component to the heat-activated foil. Attaching unit 50 may comprise a robot arm mounting the component onto the heat-activated foil.

The system 80 further comprises an installation unit 55 adapted for installing the heat-activated foil with the attached component into an assembly machine 60. Installation unit 55 may comprise a cassette holding e.g. the component in form of a wafer on the heat-activated foil, or a conveyor belt on which the heat-activated foil with the attached component is moved into assembly machine 60 which in turn may be a semiconductor assembly line. Optionally, sawing the wafer into dies may also be performed.

A heat applying unit 65, which may be a laser, may be adapted for applying heat to the component and/or the heat-activated foil in the assembly machine 60 for reducing an adhesive effect between the heat-activated foil and the component for enabling release of the component from the heat-activated foil. The heat applying unit 65 may be part of the assembly machine.

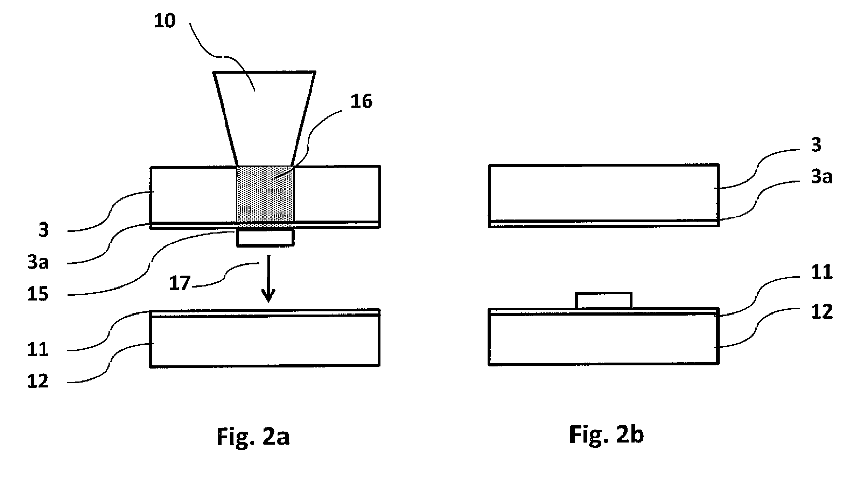

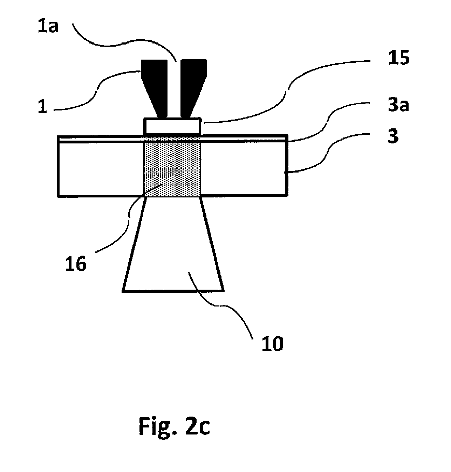

Further aspects which may be realized in system 80 are shown in Fig. 2 to Fig. 4.

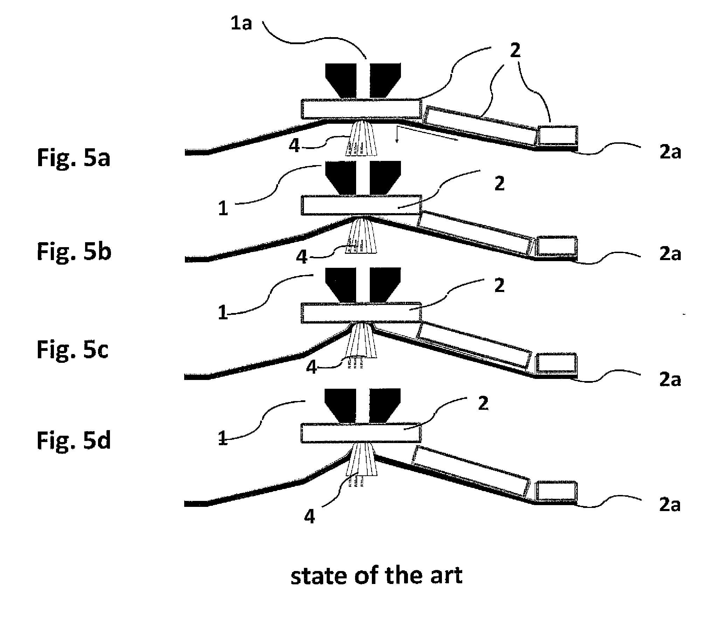

In contrast to Fig. 1, **Fig. 5a** shows a conventional way of releasing a component 2 from a conventional adhesive foil 2a. The foil 2a has an adhesive surface (not shown here). The conventional foil 2a is moved in the figure from right to left in a space between a needle 4 and a collet 1. Typically, the needle 4, the middle of the component 2 and the collet 1 are vertically aligned. The component 2 extends vertically to the plane of the figure. In the figure, a typical side view of the component 2 is shown.

In **Fig. 5b****,** the needle 4 has lifted the foil 2a, so that the left and the right end of the component are released from the foil 2a. Through a central tube 1a of the collet 1 air is sucked into the collet 1. Once the collet 1 touches the surface of the component 2, the component 2 is sucked to the collet 1 but might still be fixed with a certain area to the conventional foil 2a. In one alternative, the sucking forces are that strong that the component 2 is released from the foil 2a. In another alternative, the needle pushes further **(****Fig. 5c****),** and finally pushes through the foil 2a directly to the bottom surface of the component 2 **(****Fig. 5d****),** and finally releasing the component 2 completely from the conventional foil 2a. The collet 1 together with the component 2 can be moved and the component 2 may be placed to any target area by stopping the air sucking through the tube 1a. In Fig. 5a to Fig. 5d the component 2 may be an electronic die.

**Fig. 2a** shows a configuration according to an exemplary embodiment of the invention. In this case, the foil 3 is a heat-activated foil 3 which comprises an adhesive surface 3a. An example of the heat-activated foil is Revalpha from a company called Nitto Denko Corporation. The component, which in this case is a die 15, to be released from the heat-activated foil 3 may be fixed upside down to the adhesive surface 3a of the heat-activated foil 3. This means that the active part may face the adhesive surface 3a of the heat-activated foil 3. But an alternative orientation of the die 15 is also possible. The component may be a semiconductor die 15 comprising a plurality of electronic components. Once die 15 fixed to the heat-activated foil 3 is positioned in an area where the die 15 should be released from the heat-activated foil 3, a laser beam 10 is focused onto the back of the heat-activated foil 3, opposite to an area where the die 15 is fixed to the heat-activated foil 3. The laser beam 10 may be focused onto that area. For this purpose, the laser beam 10 might be conditioned with any kind of optical elements such as shutters, timers, diaphragm, mirrors, lenses and/or prisms and the like.

The laser beam 10 heats the area 16 of the heat-activated foil including the adhesive surface 3a of the heat-activated foil 3 for a predetermined amount of time in order to activate the heat-activated foil 3. The heat-activated foil 3 including the adhesive surface 3a reduces or loses its adhesive effect and releases the die 15. Gravitational or other forces may pull the die 15 downwards onto a receiving substrate 11 on a carrier 12. The receiving substrate 11 may also have an adhesive nature. In case the die 15 is a semiconductor die or other planar low weight components, the distance between the still attached component 15 to the adhesive surface 3a may be small, e.g., smaller than 1 mm or, mathematically spoken, even much smaller than 1 mm, e.g., as low as 0,1 mm.

**Fig. 2b** shows a status of the die 15 that is released from the heat-activated foil 3 including the adhesive surface 3a of the heat-activated foil 3. The laser beam 10 is no longer active. The die 15 has fallen down to the receiving substrate 11, which is carried by a carrier 12. It is also possible to release a plurality of dies 15 synchronously by applying heat to an area covering several dies 15 on the heat-activated foil 3. In such a way, a complete row of dies may be released from the heat-activated foil 3. One or more heat sources may be active in this case. In case just one heat source is used, the beam may be split by means of appropriate radiation split techniques. Alternatively, different areas 16 for different dies 15 may be heated individually or on groups thereof.

In an alternative embodiment, as shown in **Fig. 2c****,** the laser beam 10 is focused from below the heat-activated foil 3 with the adhesive surface 3a on top. Above this arrangement, a die 15 is shown. Again, above the die 15, a collet 1 is positioned. Once, a laser is activated and is focusing its laser beam 10 onto the heat-activated foil 3 for a certain amount of time, heating up the area 16 in the heat-activated foil 3, the die 15 is released from the heat-activated foil 3 and its adhesive surface 3a, so that the collet 1 can lift the die 15 away from the heat-activated foil 3. For this purpose, air is sucked through the tube 1a of the collet 1, sucking the die 15 towards the collet 1. Now, the collet 1 may be moved to any place and place the die 15 at any target area, e.g. by using a robotic arm. The die 15 does not need to be pushed from below by a needle 4 through the foil 3 as compared to the state of the art as shown in Fig. 5a - Fig. 5d. The die 15 can be released from the heat-activated foil 3 without the risk of any damage. The above embodiment is described in the context of a naked die 15, i.e. an unpackaged die 15. Alternatively, the method can be performed with any other component that might be fixed to a heat-activated foil 3, such as a molded component 15, an individual electric or electronic component 15, or a mechanical component 15.

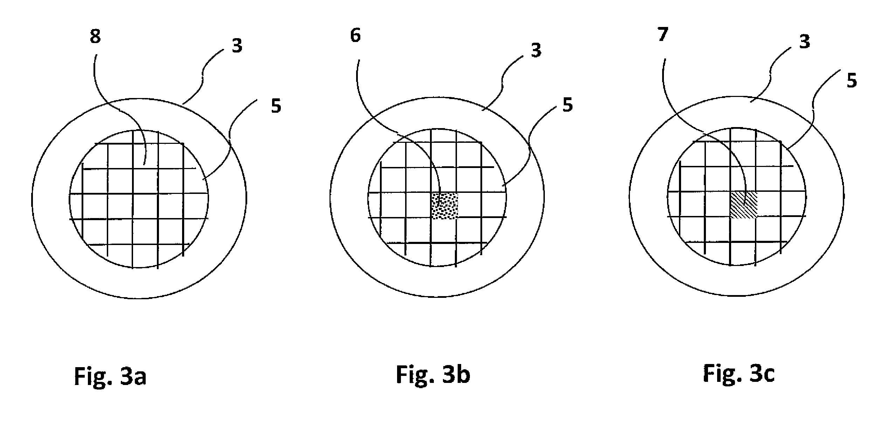

**Fig. 3a** **-** **Fig. 3c** show an exemplary embodiment of the invention for the case of a wafer 5 on a heat-activated foil 3, where individual, singulated dies 8 are sawn out of the wafer 5. Fig. 3a shows a complete wafer 5 with singulated target dies 6 on a heat-activated foil 3. In Fig. 3b, the heat-activated foil 3 is heated from the back, so that the target die 6 can be released from the heat-activated foil 3. The target die 6 is marked as a dotted area in Fig. 3b. Once the target die 6 is picked up from the heat-activated foil 3, an empty space 7 is left back in the originally complete wafer 5.

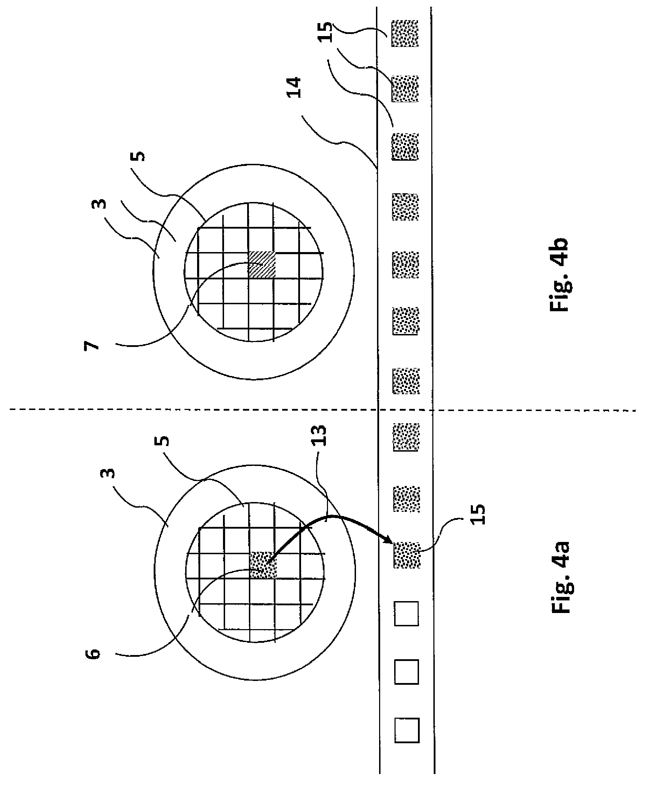

If the arrangements of Fig. 2a and Fig. 2b as well as those of Fig. 3a, Fig. 3b, and Fig. 3c are combined, the alternative embodiment of **Fig. 4a and Fig. 4b** may be obtained. Fig. 4a shows again the target die 6 and the heat-activated foil 3 heated in such an arrangement that the target die 6 may be released from the heat-activated foil 3. If the arrangement comprising the heat-activated foil 3 with a singulated wafer 5, is placed over a carrier tape 14, the released dies 15 fall onto the carrier tape or leadframe 14 by means of gravity forces. Alternatively, a collet as in figure 2c which may be mounted on a robotic arm can move the die from the foil to a carrier tape or a leadframe. Before the next die 15 can be released by heating up the heat-activated foil 3 behind the next target die 15, the next target die 15 needs to be positioned in the spatially fixed focus area of the laser beam 10 (not shown in Fig. 4a). Optionally, also the laser (or other heat source) can be repositioned. Only the relative position between the area to be heated and the heat source is important.

**Fig. 4b** shows again the empty space 7 and the wafer 5 after a target die 6 has been released from the heat-activated foil 3. This way, a series of target dies 6 may be placed on a carrier tape 14, which is may be moved at the same speed as the laser beam 10 is positioned and activated and the next target die 6 is positioned below the laser beam 10 focus area. As explained above, the carrier tape 14 might comprise a receiving substrate 11, which may be an adhesive material fixing the target dies 6 on the carrier tape 14. This carrier tape 14 carrying the single dies 15 may then be moved to the next production station. Alternatively, the laser beam 10 may be positioned behind the next target die 6 or a plurality of target dies 6 for heating up the heat-activated foil 3 in an area of a target die 6.

The laser beam 10, heating up the heat-activated foil 3, may be focused with any appropriate optical element such as lenses, diaphragms, mirrors and shutters. The timing of the laser beam 10 heating up the heat-activated foil 3 may be such that the adhesive effect of a heat-activated foil 3 is reduced or no longer effective. A timer for an activation of the laser beam 10 or a controlling shutter might be implemented as well.

Instead of a laser beam 10, any other heat-generating source may be used in order to heat up the heat-activated foil 3. Other means for heating up locally the heat-activated foil 3 include other light sources such as power LEDs, halogen lamps, IR (infrared) sources that allow a time controlled application of heat to a target area. Classical IR sources also include resistors that are activated by an electrical current. Another alternative to apply heat to the heat-activated foil 3 in order to release a die from the heat-activated foil 3 are chemical substances that can chemically react in an exothermal reaction triggered by radiation, in particular electromagnetic radiation such as light, or electricity.

It should be noted that the term "comprising" does not exclude other elements or features and the "a" or "an" does not exclude a plurality. Also elements described in association with different embodiments may be combined.

It should also be noted that reference signs in the claims shall not be construed as limiting the scope of the claims.

### REFERENCE NUMERALS

- 1: collet
- 1a: vacuum tube inside the collet
- 2: component
- 2a: conventional, adhesive foil
- 3: heat-activated foil
- 3a: adhesive layer
- 4: needle
- 5: wafer
- 6: target die
- 7: empty space after releasing a die in a wafer
- 8: dies of a singulated (singularized) wafer
- 10: laser beam
- 11: receiving substrate
- 12: carrier for receiving substrate
- 13: arrow demonstrating a drop to a carrier tape
- 14: carrier tape
- 15: dies placed on a carrier tape
- 16: heated zone of heat-activated foil
- 17: arrow showing direction of a "gravity drop"
- 50: attaching unit
- 55: installation unit
- 60: assembly machine
- 65: heat applying unit
- 80: a system for releasing a component from a heat-activated foil

## Claims

1. Method for releasing a component (6, 15) from a heat-activated foil (3), the method comprising:
a) attaching the component (6, 15) to the heat-activated foil (3),
b) installing the heat-activated foil (3) with the attached component (6, 15) into an assembly machine (60), and
c) applying heat to at least one of the component (6, 15) and the heat-activated foil (3) in the assembly machine (60) for reducing an adhesive effect between the heat-activated foil (3) and the component (6, 15) for enabling release of the component (6, 15) from the heat-activated foil (3).

2. The method of claim 1, further comprising after c)
d) picking up the released component (6, 15) with a collet (1) or dropping the component (6, 15) from the heat-activated foil (3).

3. The method of claim 1, wherein the component (6, 15) is one of the group consisting of a die, a molded component, an electronic component, an electro-mechanical component, a surface mountable component, and a through-the-hole mountable component.

4. The method of claim 2, wherein after d) the method further comprises placing the component (6, 15) on a printed circuit board.

5. The method of claim 1, wherein the assembly machine is a machine for assembling electronic components on a printed circuit board or on a carrier tape.

6. The method of claim 1, wherein the component is part of a singulated wafer (5).

7. The method of claim 6, wherein between a) and b) the method further comprises singulating the wafer (5) into dies (6, 15), one of the dies (6, 15) being the component (6, 15).

8. The method of claim 7, wherein after d) the method further comprises placing the die (6, 15) on a leadframe.

9. The method of claim 1, wherein the assembly machine is a machine for assembling dies (6, 15) on a leadframe or onto a carrier tape (14).

10. The method of claims 1, wherein the heat is produced by at least one of the group consisting of a laser, a lamp, a halogen lamp, a light emitting diode, an infrared source, radiation generated by a current flowing through a resistor, an electromagnetic field inducing a current in the component (6, 15), and a chemical reaction, particularly a chemical reaction that is activated by one of electromagnetic radiation, light and electricity.

11. The method of claim 1, wherein the assembly machine comprises one of the group consisting of a lens, a diaphragm, a shutter, a timer, a prism, and a mirror for directing radiation towards at least one of the component (6, 15) and the heat-activated foil (3).

12. The method of claim 2, wherein the collet (1) is vacuum-operated.

13. The method of claim 2, wherein dropping the component (6, 15) from the heat-activated foil (3) comprises dropping the component (6, 15) to a predefined target location.

14. The method of claim 1, wherein a) comprises attaching a wafer comprising the component in form of a die to the heat-activated foil, and the method further comprises singulating the wafer into individual dies before applying heat.

15. System (80) for releasing a component (6, 15) from a heat-activated foil (3), the system (80) comprising:
a) an attaching unit (50) adapted for attaching the component (6, 15) to the heat-activated foil (3),
b) an installation unit (55) adapted for installing the heat-activated foil (3) with the attached component (6, 15) into an assembly machine (60), and
c) a heat applying unit (65) adapted for applying heat to at least one of the component (6, 15) and the heat-activated foil (3) in the assembly machine (60) for reducing an adhesive effect between the heat-activated foil (3) and the component (6, 15) for enabling release of the component (6, 15) from the heat-activated foil (3).
